# EUROPÄISCHE PATENTSCHRIFT

(11) **EP 3 399 528 B1**
(45) Veröffentlichungstag und Bekanntmachung des Hinweises auf die Patenterteilung: **14.08.2019**
(21) Anmeldenummer: 18170518.7
(22) Anmeldetag: 03.05.2018
(51) Int. Cl.: H01F 6/06, H01F 41/04, G01R 33/34, G01R 33/38

(54) **SUPRALEITFÄHIGE MAGNETSPULENANORDNUNG MIT MEHREREN LAGENWEISE GEWICKELTEN BANDFÖRMIGEN SUPRALEITERN**
SUPERCONDUCTIVE SOLENOID ASSEMBLY WITH MULTIPLE LAYER-WOUND STRIP-SHAPED SUPERCONDUCTORS
DISPOSITIF FORMANT BOBINE MAGNÉTIQUE SUPRACONDUCTEUR À PLUSIEURS SUPRACONDUCTEURS EN FORME DE BANDE ENROULÉS PAR COUCHES

(30) Priorität: 05.05.2017 DE 102017207618
(43) Veröffentlichungstag der Anmeldung: 07.11.2018
(73) Patentinhaber: Bruker BioSpin AG, 8117 Fällanden (CH)
(72) Erfinder: Vonlanthen, Patrik, 8603 Schwerzenbach (CH); Herzog, Robert, 8002 Zürich (CH); Schauwecker, Robert, 8004 Zürich (CH)
(74) Vertreter: Kohler Schmid Möbus Patentanwälte

(56) Entgegenhaltungen:
- DE-A1- 10 202 372
- DE-A1-102011 082 652
- DE-B3-102004 043 987
- DE-B3-102004 043 989
- JP-U- H0 655 225
- US-B2- 9 117 578

## Beschreibung

Die Erfindung betrifft eine supraleitfähige Magnetspulenanordnung mit einer lagengewickelten, bezogen auf eine Symmetrieachse zylindersymmetrischen Spule zur Erzeugung eines Betriebsmagnetfeldes in einem Arbeitsvolumen um die Symmetrieachse, und mit einer die Symmetrieachse enthaltenden und die Spule schneidenden Schnittebene, wobei die Spule einen rechteckigen Spulenquerschnitt in der Schnittebene aufweist, der definiert ist durch einen radial inneren und radial äußeren sowie einen axial ersten und axial zweiten Spulenrand, definiert durch die Position einer radial innersten und einer radial äußersten Windung der Spule mit dem kleinsten bzw. größten Abstand zur Symmetrieachse, und durch die Position einer axial ersten und einer axial letzten Windung der Spule mit der kleinsten bzw. größten Koordinate entlang der Symmetrieachsenrichtung, wobei die Spule mindestens einen ersten bandförmigen Supraleiter und einen zweiten bandförmigen Supraleiter umfasst, wobei die bandförmigen Supraleiter ein Seitenverhältnis (=Breite zu Dicke) > 3 aufweisen, und wobei die bandförmigen Supraleiter in einen Bereich außerhalb des rechteckigen Spulenquerschnitts geführt und dort elektrisch verbunden sind.

Eine solche Magnetspulenanordnung ist bekannt beispielsweise aus DE 102 02 372 B4 oder US 6,774,752 B2 (=Referenzen [1] bzw. [2]). Dort werden die bandförmigen Supraleiter aus unterschiedlichem supraleitenden Material gefertigt.

### Hintergrund der Erfindung

Supraleitende Magnetspulen ermöglichen eine äußerst energieeffiziente Erzeugung von starken und zeitlich konstanten Magnetfeldern, da sie völlig ohne oder zumindest mit sehr geringen ohmschen Verlusten betrieben werden können. Die elektrische Stromtragfähigkeit eines Supraleiters ist durch seinen kritischen Strom I_{c} gegeben. Übersteigt der elektrische Strom im Leiter den Wert von I_{c}, so findet ein Phasenübergang zu einem normalleitenden Zustand statt, in welchem der Strom nicht mehr widerstandslos fließt.

In einem isotropen Supraleiter hängt die Stromtragfähigkeit von der Stärke des Magnetfeldes ab, welchem er ausgesetzt ist, nicht aber von der Richtung des Magnetfeldes in einer Ebene senkrecht zur Leiterachse. Bei einem anisotropen Supraleiter hingegen wird die Stromtragfähigkeit auch vom Winkel des Magnetfeldes zu ausgezeichneten Richtungen des Leiters beeinflusst, meist kristallographischen Richtungen. Dies ist beispielsweise bei Hochtemperatur-Supraleitern (HTS) wie (Re)BCO oder Bi-2223 der Fall, deren zugrunde liegende Kristallstruktur einen zweidimensionalen Charakter hat. So ist der kritische Strom eines bandförmigen Hochtemperatur-Supraleiters (HTS) in einem Magnetfeld, welches senkrecht zur Bandebene steht, typischerweise niedriger als in einem Feld parallel zur Bandebene.

In einer aus bandförmigem HTS gewickelten zylindersymmetrischen Magnetspule führt dies normalerweise dazu, dass die Stromtragfähigkeit der Spule an den axialen Enden des Wickelpakets limitiert ist, da dort die Radialkomponente des Magnetfeldes am größten ist.

Im Folgenden betrachten wir eine aus anisotropem Supraleiter lagengewickelte zylindersymmetrische Magnetspule, deren Stromtragfähigkeit durch die von der Spule erzeugte Feldkomponente in radialer Richtung stärker unterdrückt ist als durch diejenige in axialer Richtung. Mit "lagengewickelt" ist gemeint, dass entlang des Supraleiters aufeinanderfolgende Windungen hauptsächlich lagenweise entlang der Symmetrieachse nebeneinander gewickelt sind, wobei einer Lage jeweils ein konstanter Radius zugeordnet werden kann. Dies steht im Gegensatz zu sogenannten Pancake-Spulen, bei denen aufeinander folgende Windungen hauptsächlich radial übereinander gewickelt sind.

### Spezieller Stand der Technik

In den eingangs zitierten Druckschriften (Referenzen [1] und [2]) werden als Lösung solenoidförmige Spulensektionen offenbart, die dadurch gekennzeichnet sind, dass die radial innerste Spulensektion mit einem bandförmigen Supraleiter auf einen Spulenträger gewickelt ist, der zumindest an einem axialen Ende das Wickelpaket der radial benachbarten Spulensektion in axialer Richtung überragt, und dass der bandförmige Supraleiter auf dieser Seite tangential nach außen in einen Bereich reduzierter Magnetfeldstärke geführt ist und in mindestens eine elektrische Verbindungsstelle mündet. Zusätzlich werden als spezielle Ausführungsformen folgende Lösungen offenbart: Im Bereich reduzierter Magnetfeldstärke werden zwei bandförmige Supraleiter miteinander verbunden und mehrere bandförmige Supraleiter werden in *einer* Spulensektion gewickelt. Es werden zudem nutenartige Vertiefungen in den Oberflächen des Spulenträgers für die Bandführung offenbart und auch flexible Matten und Halbschalen mit Vertiefungen zur definierten Führung der benachbarten Wickellagen.

Nachteilig bei dieser Lösung ist, dass es keine axialen Bereiche mit unterschiedlichen bandförmigen Supraleitern gibt.

EP 2 906 961 B1 (=Referenz [3]) offenbart folgende Lösung:
Bandförmige HTS-Stücke werden innerhalb des Wickelpakets miteinander verkettet (in Serie gelötet), wobei jedes verkettete Bandstück jeweils mit wenigstens zwei weiteren Bandstücken derart verbunden ist, dass die weiteren Bandstücke zusammen im Wesentlichen mit der gesamten Länge des verketteten Bandstücks überlappen. In Fig. 11 der Druckschrift wird als Beispiel eine Spulensektion mit drei Teilbereichen in axialer Richtung offenbart, wobei die Randbereiche mit einem Einfachband ausgebildet sind und der mittlere Bereich mit einem Doppelband ausgebildet ist.

Nachteile dieser Lösung sind: Schwieriger Lötprozess innerhalb der Spule, insbesondere müssen sehr lange Bandlängen gelötet werden um einen niederohmigen Widerstand zu erhalten. Die Lötverbindungen (Joints) sind nicht supraleitend. Homogenitätsprobleme könnten durch die Dicken-Variationen der Bänder im gelöteten Bereich auftreten. Das gleichmäßige Anbringen der elektrischen Isolierung an der Lötstelle ist schwierig.

DE 10 2004 043 987 B3 (=Referenz [4]) beschreibt, wie ein bandförmiger Supraleiter von einer Teilkammer in eine andere Teilkammer über eine einlagige Überführungs-wicklung über die Kegelstumpfförmige Mantelfläche des ersten Trennkörpers geführt ist, wobei ein zweiter Trennkörper vorgesehen ist, der den ersten Trennkörper im Notchbereich radial nach außen hin zu einem Kreiszylinder ergänzt, wobei die einlagige Überführungswicklung zwischen den Trennkörpern angeordnet ist.

Nachteil dieser Lösung ist, dass der Trennkörper einen Notch-Bereich definieren soll und daher einen großen axialen Bereich abdeckt. In Figur 1 dieser Druckschrift sind es 4 Windungen.

Für Spulenanordnungen, die mit "double pancakes" gewickelt werden, kann der Ansatz mit verschiedenen Leiterbreiten entsprechend US 9,117,578 B2 (=Referenz [5]) angewendet werden, wobei die breiteren Leiter mit erhöhter Stromtragfähigkeit am Rand der Spule platziert werden. Solche Spulenanordnungen sind für NMR Anwendungen sowohl aufgrund der zu geringen Feldstabilität (große Anzahl an Lötverbindungen, daher relativ hoher Widerstand) als auch der ungenügenden Feldhomogenität (Stromverteilung räumlich zu ungleichmäßig) schlecht geeignet.

Weitere supraleitfähige Magnetspulenanordnungen sind in DE 10 2011 082 652 A1 und DE 10 2004 043 989 B3 offenbart.

### Aufgabe der Erfindung

Der vorliegenden Erfindung liegt demgegenüber die Aufgabe zugrunde, eine supraleitfähige Magnetspulenanordnung der eingangs definierten Art sowie ein Verfahren zu deren Herstellung mit besonders einfachen technischen Mitteln so zu modifizieren, dass die oben diskutierten Einschränkungen von derartigen, bekannten supraleitfähigen Magnetspulenanordnungen vermieden, jedenfalls aber deutlich abgemildert werden. Insbesondere soll eine Magnetspulenanordnung mit mehreren anisotropen bandförmigen HTS-Stücken pro Spule lagenweise gewickelt werden, um mit einem möglichst homogenen Wickelpaket ein besonders homogenes Magnetfeld zu erzeugen. Mit den oft aus bandförmigen HTS gewickelten, bekannten "double pancakes" ist dies erheblich schwieriger. Da sich das Magnetfeld in Stärke und Richtung innerhalb einer Magnetspule entlang der Richtung parallel zur Spulenachse (z-Koordinate) deutlich ändert und die Stromtragfähigkeit der bandförmigen Supraleiter stark vom Magnetfeld und insbesondere von der Magnetfeldrichtung abhängt, ist es wünschenswert, bandförmige Supraleiter mit verschiedenen Stromtragfähigkeiten als Funktion der Magnetfeldstärke und der Magnetfeldrichtung in axial verschiedenen Bereichen zu wickeln (beispielsweise breitere Leiter am Rand der Spulen wickeln, da dort hohe radiale Felder auftreten).

### Kurze Beschreibung der Erfindung

Diese Aufgabe wird auf ebenso überraschend einfache wie wirkungsvolle Weise sowie mit ohne Weiteres zur Verfügung stehenden technischen Mitteln durch eine supraleitfähige Magnetspulenanordnung gemäss Anspruch 1 gelöst, welche folgende Merkmale aufweist:
Einen ersten rechteckigen Teilbereich innerhalb des rechteckigen Spulenquerschnitts, welcher den Spulenquerschnitt entlang der Symmetrieachsenrichtung vollständig überdeckt,
mindestens einen zweiten und dritten rechteckigen Teilbereich innerhalb des ersten rechteckigen Teilbereichs, welche den ersten rechteckigen Teilbereich jeweils radial vollständig und axial teilweise überdecken, wobei der zweite rechteckige Teilbereich vollständig mit dem ersten bandförmigen Supraleiter gewickelt ist und der dritte rechteckige Teilbereich vollständig mit dem zweiten bandförmigen Supraleiter gewickelt ist, und wobei der zweite und der dritte rechteckige Teilbereich disjunkt sind,
wobei die bandförmigen Supraleiter unterschiedliche supraleitende Stromtragfähigkeiten bei gleichem Feld, bei gleicher Feldrichtung relativ zur Bandebene und bei gleicher Temperatur aufweisen.

### Wirkungsweise der Erfindung und weitere Vorteile gegenüber dem Stand der Technik

Die Erfindung betrifft eine Anordnung, bei der mehrere bandförmige Supraleiter auf einen Spulenkörper gewickelt werden, wobei mindestens zwei bandförmige Supraleiter axial außerhalb des Wickelpakets niederohmig in Serie verbunden werden (z.B. durch Löten) und die bandförmigen Supraleiter sich innerhalb des Wickelpakets größtenteils in axial verschiedenen Bereichen befinden.

Weitere Vorteile der Erfindung:
- Die Stromdichte innerhalb des Wickelpakets kann erhöht werden (oder weniger bandförmiger Supraleiter muss gewickelt werden um das gleiche Feld zu erzeugen), da in axial verschiedenen Bereichen, entsprechend der Magnetfeldverteilung, unterschiedliche Leiter eingesetzt werden können.
- Die in einem Bereich niedrigen Magnetfelds mögliche Anordnung der elektrischen Verbindungen (Joints) erlaubt einfachere und/oder niederohmigere oder sogar supraleitende Joints.
- Es ist einfacher möglich ein sehr homogenes Wickelpaket zu erhalten, da Joints außerhalb des Wickelpakets angeordnet sein können (im Gegensatz zu den in Referenz [3] vorgeschlagenen Lötverbindungen innerhalb des Wickelpakets).
- Durch das Wickeln der Ein- und Ausgänge größtenteils in den innersten Lagen kann durch die geeignete Wahl der Leitergeometrie oder der Wickeltechnik gewährleistet werden, dass die Radialfeldkomponenten am Rand reduziert werden und somit die Stromtragfähigkeit aller bandförmigen Supraleiter auch beim Herausführen hoch bleibt.

### Bevorzugte Ausführungsformen der Erfindung

Bei einer Klasse von Ausführungsformen der erfindungsgemäßen Magnetspulenanordnung ist die Anzahl der Lagen des ersten rechteckigen Teilbereichs größer als 3.

Im Allgemeinen ist es vorteilhaft, Wickelpakete mit mindestens drei Lagen zu wickeln, da man sonst sehr viele elektrische Verbindungen braucht.

Es ist nämlich vorteilhaft, Wickelpakete mit mehr als drei Windungen pro Lage zu wickeln, insbesondere um ein möglichst homogenes Magnetfeld zu erreichen.

Besonders bevorzugt sind auch Ausführungsformen der Erfindung, bei denen die bandförmigen Supraleiter so gewählt sind, dass ihre supraleitende Stromtragfähigkeit sowohl von der Feldamplitude als auch von der Feldrichtung relativ zur Bandebene abhängt.
Diese Lösung ist besonders vorteilhaft für anisotrope Supraleiter, d.h. für Leiter, bei denen die kritische Stromdichte stark vom Radialfeld beeinflusst wird. Es können entsprechend den Bedürfnissen unterschiedliche Arten von Supraleitern in axial unterschiedliche Bereiche gewickelt werden, etwa Leiter mit hohem I_{c} an den axialen Rändern der Spule.

Weitere vorteilhafte Ausführungsformen der erfindungsgemäßen Magnetspulenanordnung zeichnen sich dadurch aus, dass ein Unterschied in der supraleitenden Stromtragfähigkeit der bandförmiger Supraleiter dadurch zustande kommt, dass die Breite und/oder die Dicke der supraleitenden Schicht und/oder die Materialeigenschaften, insbesondere die chemische Zusammensetzung der supraleitenden Schicht unterschiedlich gewählt sind. Durch Wahl dieser Eigenschaften der bandförmigen Supraleiter kann ihre supraleitende Stromtragfähigkeit besonders präzis an die unterschiedlichen Bedingungen hinsichtlich Feldstärke und -richtung in verschiedenen Teilbereichen der Spule angepasst werden.

Besonders bevorzugt sind auch Ausführungsformen der erfindungsgemäßen Spulenanordnung, bei denen der Querschnitt des ersten bandförmigen Supraleiters sich unterscheidet vom Querschnitt des zweiten bandförmigen Supraleiters.
Das Wickeln stark unterschiedlicher Leiter kann einerseits vorteilhaft für die Stromauslastung (I/I_{c}) sein, andererseits zur Reduktion der Radialfeldkomponente am Rand der Spule beitragen. Es können auch verschiedene Leiter in axial verschiedenen Bereichen zur Optimierung der mechanischen Belastung ausgewählt werden.

Vorteilhaft sind auch Ausführungsformen der Erfindung, die sich dadurch auszeichnen, dass die bandförmigen Supraleiter über eine Fläche > 1cm², vorzugsweise > 10 cm², mit einem Übergangswiderstand kleiner als 10⁻⁶ Ohm, vorzugsweise < 10⁻⁸ Ohm, miteinander verlötet oder mit einem Übergangswiderstand kleiner als 10⁻⁸ Ohm supraleitend verbunden sind. Damit kann die Magnetspule im "persistent mode" betrieben werden.

In der Praxis bewähren sich auch Ausführungsformen der erfindungsgemäßen Spulenanordnung, bei welchen die bandförmigen Supraleiter aus einem HTS-Material bestehen, insbesondere vom Typ ReBCO (Re = "rare earth", z.B. Yttrium). Hochtemperatur-Supraleiter sind die wichtigsten anisotropen Supraleiter für praktische Anwendungen.

In besonders bevorzugten Ausführungsformen der Erfindung ist die Magnetspulenanordnung ein NMR-Hochfeldmagnet, in dessen Zentrum ein homogenes Magnetfeld erzeugt wird.
Die erfindungsgemäßen Spulenanordnungen eignen sich besonders für NMR Anwendungen, weil damit die Erzeugung eines besonders starken, konstanten, und homogenen Magnetfelds ermöglicht wird.

Bei einer weiteren, wichtigen Klasse von Ausführungsformen der erfindungsgemäßen Magnetspulenanordnung sind mindestens zwei bandförmige Supraleiter in einem zweiten und einem dritten rechteckigen Teilbereich durch Keile getrennt.
Die Verwendung von Keilen ermöglicht präzise Wicklungen und daher sehr homogene Magnete, wie sie etwa für hochauflösende NMR Spektrometer benötigt werden.

Vorteilhafte Weiterbildungen dieser Ausführungsformen sind dadurch gekennzeichnet, dass mindestens ein bandförmiger Supraleiter mit einem ersten Keil von einer ersten Lage zu einer zweiten, radial weiter innen liegenden, Lage geführt wird.
Die Verwendung eines speziell geformten Keils ist eine der Möglichkeiten, axial getrennte Wickelpakete zu wickeln. Eine andere Möglichkeit wird weiter unten beschrieben.

Bei besonders vorteilhaften Varianten dieser Weiterbildungen ist ein zweiter Keil als Gegenstück zum ersten Keil vorgesehen, der einen Anschlag für das Wickeln eines zweiten bandförmigen Supraleiters bildet.
Mit dem zweiten Keil kann platzsparend für das zweite Wickelpaket ein sauberer Anschlag gebildet werden.

Andere Weiterbildungen der oben beschriebenen Klasse von bevorzugten Ausführungsformen sind dadurch gekennzeichnet, dass die Keile folgende Parameter aufweisen:
a) 0 ≤ A ≤ 4mm, insbesondere A < 1mm, wobei A die Breite des dünnen Keil-Endes bedeutet,
b) B = A + W, wobei B die Breite des dicken Keil-Endes und W die Breite eines bandförmigen Supraleiters bedeuten,
c) die Keile erstrecken sich entlang einer vollen Windung des bandförmigen Supraleiters mit einer konstanten Höhe ΔR. Die Höhe ΔR geht stetig zu 0 im
Anschluss an die volle Windung innerhalb eines Winkels α < 180°, vorzugsweise innerhalb α < 60°.
Diese Keilform ist besonders vorteilhaft, da innerhalb einer Windung der Leiter von einer ersten Lage zu einer zweiten, radial weiter innen liegenden, Lage geführt werden kann.

Schließlich zeichnen sich weitere vorteilhafte Weiterbildungen dadurch aus, dass mehrere bandförmige Supraleiter über ein und denselben Keil geführt sind.

In den Rahmen der vorliegenden Erfindung fällt auch ein Verfahren zur Herstellung einer supraleitfähigen Magnetspulenanordnung der oben beschriebenen, erfindungsgemäßen Art durch Wickeln von mindestens zwei bandförmigen Supraleitern in mindestens einen zweiten und dritten rechteckigen Teilbereich, welches sich durch folgende Schritte auszeichnet:
- Wickeln mindestens einer Lage des ersten bandförmigen Supraleiters lagenweise entlang der Symmetrieachsenrichtung in einem zweiten rechteckigen Teilbereich;
- Wickeln mindestens zweier Lagen des zweiten bandförmigen Supraleiters lagenweise entlang der Richtung der Symmetrieachse in einem dritten rechteckigen Teilbereich, wobei ein Reservoir mit einer später benötigten Menge des ersten bandförmigen Supraleiters mitdreht;
- Wickeln mindestens einer weiteren Lage des ersten bandförmigen Supraleiters über den im vorgängigen Schritt gewickelten zweiten bandförmigen Supraleiter mit der im Reservoir aufbewahrten Bandlänge des ersten bandförmigen Supraleiters.

Ein wesentlicher Vorteil dieses Verfahrens besteht darin, dass damit auf einfache Weise axial getrennte Wickelpakete gewickelt werden können.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Figuren

Die Erfindung ist in den Figuren der Zeichnung dargestellt und wird anhand von Ausführungsbeispielen näher erläutert. Es zeigen:
- Fig. 1a: eine schematische Schnittdarstellung durch eine erste Ausführungsform der erfindungsgemäßen Magnetspulenanordnung in einer die Symmetrieachse z enthaltenden Ebene mit der relativen geometrischen Anordnung der vier definierten rechteckigen Teilbereiche der Spule (aus Symmetriegründen ist nur eine Hälfte der Spule dargestellt);
- Fign. 1b-d: schematische Schnittdarstellungen weiterer Ausführungsformen der erfindungsgemäßen Magnetspulenanordnung;
- Fig. 2: eine schematische Schnittdarstellung einer Ausführungsform mit mehr als zwei bandförmigen Supraleitern (hier insgesamt sechs Leiter) in mehr als 3 eigenen Wickelbereichen (hier acht Wickelbereiche);

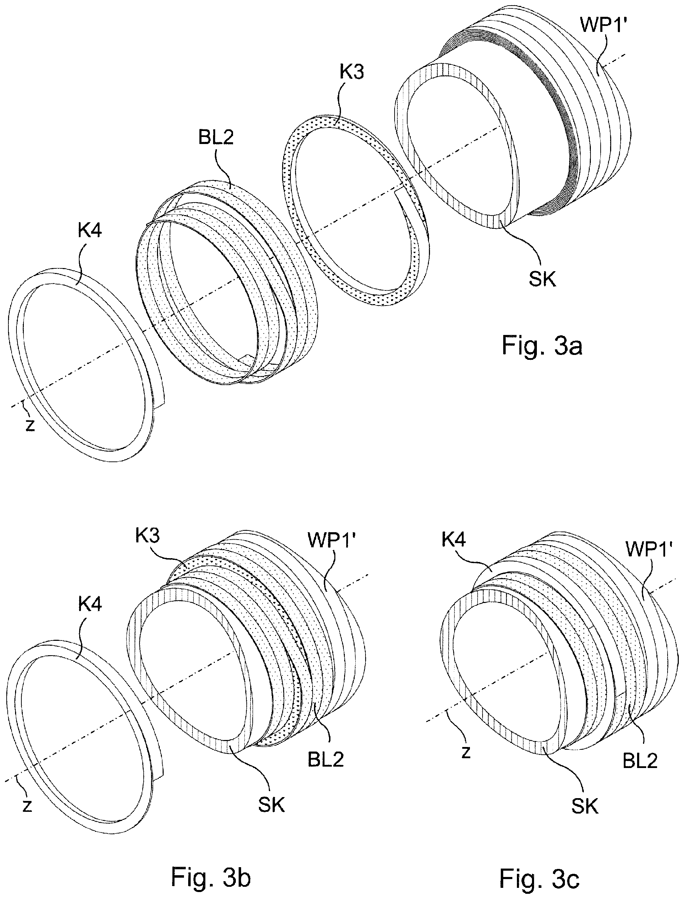

- Fign. 3a-b: Explosionszeichnungen eines Überganges eines zweiten bandförmigen Supraleiters (BL2) von einem größeren Radius (rechts) zu einem kleineren Radius (links) über einen dritten Keil (K3). Der zweite bandförmige Supraleiter (BL2) ist rechts über dem Wickelpaket (WP1') aus einem ersten bandförmigen Supraleiter (BL1) (größerer Radius) gewickelt, links jedoch auf einem kleineren Radius, hier direkt auf dem Spulenkörper (SK). Ein vierter Keil (K4) deckt den Übergangsbereich ab und füllt den minimal notwendigen Raum auf, um eine rotationssymmetrische Wickelkammer (links) zu erhalten. Der entstandene Anschlag liegt in einer Ebene senkrecht zur Symmetrieachse (z);
- Fig. 3c: eine Zeichnung des Überganges des zweiten bandförmigen Supraleiters (BL2) mit allen Komponenten in endgültiger Lage;
- Fig. 4: eine Ansicht der geometrischen Details eines Keils (K1; K2; K3; K4) für den erfindungsgemäßen Einsatz;
- Fig. 5: eine Reservoir-Anordnung für eine zwischengelagerte Länge eines bandförmigen Supraleiters (BL1).

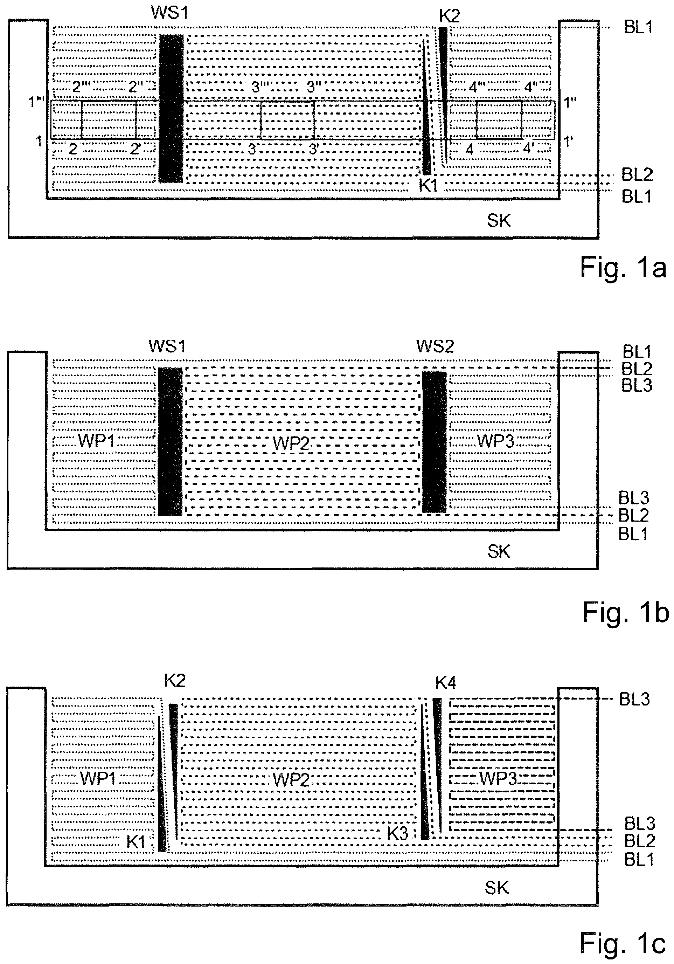

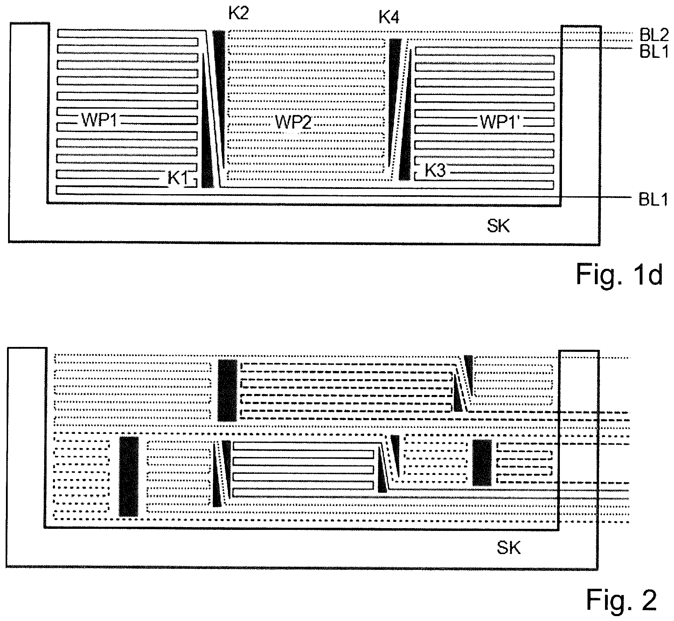

Die Figuren 1a-1d veranschaulichen schematisch verschiedene Ausführungsformen der erfindungsgemäßen Magnetspulenanordnung, wobei der Übersichtlichkeit halber aber nur in Fig. 1a die mit Bezugsziffern explizit markierte Teilbereiche eingezeichnet sind. Für die Ausführungsformen der Figuren 1b-1d sowie auch der Fig. 2 sind die entsprechenden Teilbereiche analog zu denken.

Im Wickelpaket der Spule sind die Teilbereiche der Spule innerhalb des rechteckigen Spulenquerschnitts definierbar, die den bestimmten, erfindungsgemäßen Anforderungen genügen, wie im Folgenden beschrieben wird. Dabei sind die **rechteckigen Teilbereiche** durch ihre mit den Bezugsziffern **1; 1'; 1"; 1'" bzw. 2; 2'; 2"; 2'" bzw. 3; 3'; 3"; 3'" bzw. 4; 4'; 4"; 4'"** versehenen jeweiligen Eckpunkte des entsprechenden Teilbereichs markiert. Der vierte rechteckige Teilbereich 4; 4'; 4"; 4'" befindet sich in einem anderen Raumbereich der Spule als der dazu analoge zweite rechteckige Teilbereich 2; 2'; 2"; 2"'. Beide Teilbereiche 2; 2'; 2"; 2"' und 4; 4'; 4"; 4"' weisen analoge physikalische Eigenschaften auf.

Die vorliegende Erfindung basiert auf einer supraleitfähigen Magnetspulenanordnung mit einer lagengewickelten, bezogen auf eine **Symmetrieachse z** zylindersymmetrischen Spule zur Erzeugung eines Betriebsmagnetfeldes in einem Arbeitsvolumen um die Symmetrieachse z, und mit einer die Symmetrieachse z enthaltenden und die Spule schneidenden Schnittebene, wobei die Spule einen rechteckigen Spulenquerschnitt in der Schnittebene aufweist, der definiert ist durch einen radial inneren und radial äußeren sowie einen axial ersten und axial zweiten Spulenrand, definiert durch die Position einer radial innersten und einer radial äußersten Windung der Spule mit dem kleinsten bzw. größten Abstand zur Symmetrieachse z, und durch die Position einer axial ersten und einer axial letzten Windung der Spule mit der kleinsten bzw. größten Koordinate entlang der Symmetrieachsenrichtung, wobei die Spule mindestens einen **ersten bandförmigen Supraleiter BL1** und einen **zweiten bandförmigen Supraleiter BL2** umfasst, wobei die bandförmigen Supraleiter ein Seitenverhältnis (Breite zu Dicke) > 3 aufweisen, und wobei die bandförmigen Supraleiter BL1; BL2 in einen Bereich außerhalb des rechteckigen Spulenquerschnitts geführt und dort elektrisch verbunden sind.

Vorzugsweise ist die erfindungsgemäße Magnetspulenanordnung ein NMR-Hochfeldmagnet, in dessen Zentrum ein homogenes Magnetfeld erzeugt wird.

Von anderen, bereits bekannten Magnetspulenanordnungen unterscheidet sich die vorliegende, erfindungsgemäße Anordnung dadurch, dass sie folgende Merkmale aufweist:
einen ersten rechteckigen Teilbereich 1; 1'; 1"; 1"' innerhalb des rechteckigen Spulenquerschnitts, welcher den Spulenquerschnitt entlang der Symmetrieachsenrichtung vollständig überdeckt,
mindestens einen zweiten und dritten rechteckigen Teilbereich 2; 2'; 2"; 2'" und 3; 3'; 3"; 3'" innerhalb des ersten rechteckigen Teilbereichs 1; 1'; 1"; 1"', welche den ersten rechteckigen Teilbereich radial vollständig und axial teilweise überdecken, wobei der zweite rechteckige Teilbereich 2; 2'; 2"; 2'" vollständig mit dem ersten bandförmigen Supraleiter BL1 gewickelt ist und der dritte rechteckige Teilbereich 3; 3'; 3"; 3'" vollständig mit dem zweiten bandförmigen Supraleiter BL2 gewickelt ist, und wobei der zweite und der dritte rechteckige Teilbereich 2; 2'; 2"; 2'" und 3; 3'; 3"; 3'" disjunkt sind.

Dabei weisen die bandförmigen Supraleiter BL1; BL2 unterschiedliche supraleitende Stromtragfähigkeiten bei gleichem Feld, bei gleicher Feldrichtung relativ zur Bandebene und bei gleicher Temperatur auf.

Bei den gezeigten Ausführungsbeispielen ist die Anzahl der Lagen des ersten rechteckigen Teilbereichs 1; 1'; 1"; 1'" größer 3 und die Anzahl Windungen pro Lage im zweiten und dritten rechteckigen Teilbereich 2; 2'; 2"; 2'" und 3; 3'; 3"; 3'" ebenfalls größer 3 gewählt.

Die bandförmigen Supraleiter BL1; BL2 sind so ausgesucht, dass ihre supraleitende Stromtragfähigkeit sowohl von der Feldamplitude als auch von der Feldrichtung relativ zur Bandebene abhängt.

Ein Unterschied in der supraleitenden Stromtragfähigkeit der bandförmigen Supraleiter BL1; BL2 kann dadurch zustande kommen, dass die Breite und/oder die Dicke der supraleitenden Schicht und/oder die Materialeigenschaften der supraleitenden Schicht unterschiedlich gewählt sind.

Der Querschnitt des ersten bandförmigen Supraleiters BL1 kann unterschiedlich vom Querschnitt des zweiten bandförmigen Supraleiters BL2 gewählt sein.

Die bandförmigen Supraleiter BL1; BL2 bestehen in der Regel aus einem HTS-(=Hochtemperatur-Supraleiter)-Material, insbesondere vom Typ ReBCO (Re = "rare earth", z.B. Yttrium). Sie sind über eine Fläche > 1cm², vorzugsweise > 10cm², mit einem Übergangswiderstand kleiner als 10⁻⁶ Ohm, vorzugsweise kleiner als 10⁻⁸ Ohm, miteinander verlötet oder mit einem Übergangswiderstand kleiner als 10⁻⁸ Ohm supraleitend verbunden.

Um eine sehr präzise Wicklung und daher einen sehr homogenen Magneten zu ermöglichen, wichtig insbesondere für NMR-Magnete, sind bei den in den Figuren dargestellten Ausführungsbeispielen mindestens zwei der bandförmigen Supraleiter BL1; BL2 im zweiten und im dritten rechteckigen Teilbereich 2; 2'; 2"; 2'" und 3; 3'; 3"; 3'" durch einen **ersten Keil K1** und einen **zweiten Keil K2** getrennt. Mindestens ein bandförmiger Supraleiter BL1 ist mit einem ersten Keil K1 von einer ersten Lage zu einer zweiten, radial weiter innen liegenden, Lage geführt. Der zweite Keil K2 wirkt als Gegenstück zum ersten Keil K1 und bildet einen Anschlag für das Wickeln eines zweiten bandförmigen Supraleiters BL2.

Wie aus den Figuren 1a, 1c, 1d und 2 hervorgeht, können mehrere bandförmige Supraleiter BL1; BL2 über ein und denselben Keil K1 geführt werden.

Fig. 1a zeigt eine besonders vorteilhafte Variante der Erfindung. Dabei wird ein bandförmiger Supraleiter BL1 in verschiedene Bereiche des Spulenquerschnitts (hier an den Rändern der Spule) gewickelt. Vorzugsweise hat der am Rand gewickelte bandförmige Supraleiter BL1 eine höhere Stromtragfähigkeit (z.B. durch größere Breite) als der in der Mitte gewickelte bandförmige Supraleiter BL2.

In den Anordnungen der Figuren 1a und 1c wurde zusätzlich darauf geachtet, dass die bandförmigen Supraleiter BL1; BL2; BL3 sich nicht kreuzen und alle Ein- und Ausgänge (außer der Ausgang des letzten Abschnitts) radial innen (im Bereich des **Spulenkörpers SK**) herausgeführt werden. In diesem Bereich kann die Feldkomponente normal zur Bandebene mit verschiedenen Methoden lokal reduziert werden:
- Reduktion der Wickeldichte;
- Feldbeeinflussung durch einen Ferromagneten, z.B. Eisen (*field shaping*);
- Einkerbungen im Spulenkörper SK um die Orientierung des bandförmigen Supraleiters zu ändern (Alle eingehenden Leiter können übereinander gewickelt werden und alle ausgehenden Leiter übereinander (dazwischen ist ein Einsatz nötig) ähnlich zu Referenz [1]).

Möglich ist auch eine Kombinationen dieser Methoden.

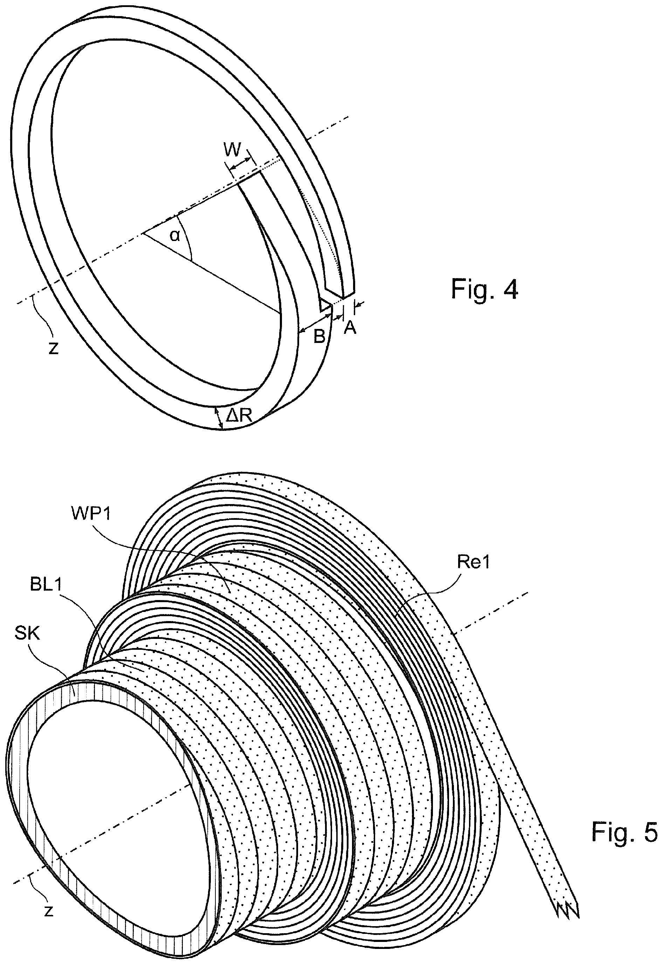

Fig. 1b zeigt eine besonders einfache Variante der Erfindung. Es werden drei bandförmige Supraleiter BL1; BL2; BL3 gewickelt und entsprechend werden je drei Ein- und drei Ausgänge benötigt. Nicht dargestellt sind hier die Verbindungen zwischen den bandförmigen Supraleitern BL1; BL2; BL3, die sich außerhalb der Spule befinden. Die Wickeltechnik ist lagenweise, doch die drei bandförmigen Supraleiter BL1; BL2; BL3 befinden sich größtenteils in axial getrennten Bereichen. Während des Wickelns werden mit dem Spulenkörper SK mitdrehende **Reservoirs Re1; Re2** ("Bandlager") benötigt, wie in Fig. 5 dargestellt. Demnach handelt es sich um eine Anwendung des erfindungsgemäßen Verfahrens, gekennzeichnet durch Wickeln von mindestens zwei bandförmigen Supraleitern BL1, BL2 in mindestens einen zweiten und dritten rechteckigen Teilbereich 2; 2'; 2"; 2'" und 3; 3'; 3"; 3'", gekennzeichnet durch folgende Schritte:
- Wickeln mindestens einer Lage des ersten bandförmigen Supraleiters BL1 lagenweise entlang der Symmetrieachsenrichtung in einem zweiten rechteckigen Teilbereich 2; 2'; 2"; 2"',
- Wickeln mindestens zweier Lagen des zweiten bandförmigen Supraleiters BL2 lagenweise entlang der Richtung der Symmetrieachse z in einem dritten rechteckigen Teilbereich 3; 3'; 3"; 3"', wobei ein Reservoir Re1 mit einer später benötigten Menge des ersten bandförmigen Supraleiters BL1 mitdreht,
- Wickeln mindestens einer weiteren Lage des ersten bandförmigen Supraleiters BL1 über den im vorgängigen Schritt gewickelten zweiten bandförmigen Supraleiter BL2 mit der im Reservoir Re1 aufbewahrten Bandlänge des ersten bandförmigen Supraleiters BL1.

Die Ausführungsform nach Fig. 1b erfordert folgende Wickelfolge:
a. Mit einem ersten bandförmigen Supraleiter BL1 wird eine Lage vom Bandeingang bis zum gegenüber liegenden Ende der Wickelkammer gewickelt.
b. Mit dem ersten bandförmigen Supraleiter BL1 werden mehrere Lagen eines **ersten Wickelpakets WP1** in einem ersten axial begrenzten Wickelbereich gewickelt. Dieser Wickelbereich ist auf einer Seite durch einen Flansch am dem Bandeingang gegenüberliegenden Ende der Wickelkammer begrenzt und auf der anderen Seite durch **erste Wickelscheiben WS1** (beispielsweise zwei Halbschalen). Die ersten Wickelscheiben WS1 können nach dem Wickeln des ersten Wickelpaketes WP1 entfernt werden.
c. Vom ersten bandförmigen Supraleiter BL1 wird die zum späteren Wickeln bis zum Bandausgang aus der Wickelkammer benötigte Leiterlänge auf ein erstes Reservoir Re1 gewickelt. Dieses erste Reservoir Re1 dreht sich beim Wickeln weiterer bandförmiger Supraleiter BL2; BL3 mit.
d. Ein zweiter bandförmiger Supraleiter BL2 wird vom Bandeingang bis zum Ende des ersten Wickelbereichs gewickelt.
e. Mit dem zweiten bandförmigen Supraleiter BL2 werden mehrere Lagen eines **zweiten Wickelpakets WP2** in einem zweiten axial begrenzten Wickelbereich gewickelt. Dieser Wickelbereich ist auf einer Seite durch das erste Wickelpaket WP1 oder durch die ersten Wickelscheiben WS1 begrenzt und auf der anderen Seite durch **zweite Wickelscheiben WS2** (beispielsweise zwei Halbschalen). Die zweiten Wickelscheiben WS2 können nach dem Wickeln des zweiten Wickelpaketes WP2 entfernt werden.
f. Vom zweiten bandförmigen Supraleiter BL2 wird die zum späteren Wickeln bis zum Bandausgang aus der Wickelkammer benötigte Leiterlänge auf ein zweites Reservoir Re2 gewickelt. Dieses zweite Reservoir Re2 dreht sich beim Wickeln weiterer bandförmiger Supraleiter BL3 mit.
g. Ein dritter bandförmiger Supraleiter BL3 wird vom Bandeingang bis zum Ende des zweiten Wickelbereichs gewickelt.
h. Mit dem dritten bandförmigen Supraleiter BL3 werden mehrere Lagen eines **dritten Wickelpakets WP3** in einem dritten axial begrenzten Wickelbereich gewickelt. Dieser Wickelbereich ist auf einer Seite durch das zweite Wickelpaket WP2 oder durch die zweiten Wickelscheiben WS2 begrenzt und auf der anderen Seite durcheinen Flansch am Bandeingangs-Ende der Wickelkammer.
i. Der dritte bandförmige Supraleiter BL3 wird durch den Bandausgang aus der Wickelkammer hinaus geführt.
j. Der zweite und danach der erste bandförmige Supraleiter BL2; BL1 werden durch Abwickeln aus dem zweiten beziehungsweise ersten Reservoir Re2; Re1 bis zum Bandausgang fertig gewickelt und aus der Wickelkammer hinaus geführt.

Wenn mehr als drei bandförmige Supraleiter gewickelt werden sollen, werden die Schritte d, e und f für jeden zusätzliche bandförmigen Supraleiter wiederholt.

Im erfindungsgemäßen Wickelverfahren können Reservoirs Re1; Re2 über ein im Zuge des Wickelverfahrens auf einen Spulenkörper SK aufgewickeltes Wickelpaket WP1; WP2 gewickelt werden (Fig. 5). Alternativ dazu können Vorratsspulen, von welchen die bandförmigen Supraleiter BL1; BL2 abgewickelt werden, als Reservoirs Re1; Re2 beim Wickeln weiterer bandförmiger Supraleiter BL2; BL3 mit gedreht werden.

Fig. 1c zeigt eine weitere einfache Variante der Erfindung. Es werden drei bandförmige Supraleiter BL1; BL2; BL3 gewickelt und entsprechend werden je drei Ein- und drei Ausgänge benötigt. Nicht dargestellt sind die Verbindungen zwischen den bandförmigen Supraleitern BL1; BL2; BL3, die sich außerhalb der Spule befinden. Die Wickeltechnik ist lagenweise, doch die drei bandförmiger Supraleiter BL1; BL2; BL3 befinden sich größtenteils in axial getrennten Bereichen. Bei dieser Wickeltechnik werden die bandförmiger Supraleiter BL1; BL2 mit je einer Anordnung von Keilen K1; K2 beziehungsweise K3; K4 nahe zum Wickelgrund (d.h. zum inneren Radius) geführt.
a. Mit einem ersten bandförmiger Supraleiter BL1 wird eine Lage vom Bandeingang bis zum gegenüber liegenden Ende der Wickelkammer gewickelt.
b. Mit dem ersten bandförmiger Supraleiter BL1 werden mehrere Lagen eines ersten Wickelpakets WP1 in einem ersten axial begrenzten Wickelbereich gewickelt. Dieser Wickelbereich ist auf einer Seite durch einen Flansch am dem Bandeingang gegenüber liegenden Ende der Wickelkammer begrenzt und auf der anderen Seite durch einen ersten Keil K1.
c. Der erste bandförmiger Supraleiter BL1 wird über den ersten Keil K1 zum Wickelgrund geführt.
d. Der erste bandförmiger Supraleiter BL1 wird bis zum Bandausgang gewickelt und aus der Wickelkammer hinaus geführt.
e. Ein zweiter bandförmiger Supraleiter BL2 wird vom Bandeingang bis zum Ende des ersten Wickelbereichs gewickelt. Ein zweiter Keil K2 wird an den ersten Keil K1 gelegt, so dass ein Anschlag zur Begrenzung eines zweiten Wickelpaketes WP2 entsteht, wobei dieser Anschlag in einer Ebene senkrecht zur Symmetrieachse z der Magnetspulenanordnung liegt.
f. Mit dem zweiten bandförmiger Supraleiter BL2 werden mehrere Lagen eines zweiten Wickelpakets WP2 in einem zweiten axial begrenzten Wickelbereich gewickelt. Dieser Wickelbereich ist auf einer Seite durch die Anordnung der Keile K1; K2 begrenzt und auf der anderen Seite durch einen dritten Keil K3.
g. Der zweite bandförmiger Supraleiter BL2 wird über den dritten Keil K3 zum Wickelgrund geführt.
h. Der zweite bandförmiger Supraleiter BL2 wird bis zum Bandausgang gewickelt und aus der Wickelkammer hinaus geführt.
i. Ein dritter bandförmiger Supraleiter BL3 wird vom Bandeingang bis zum Ende des zweiten Wickelbereichs gewickelt. Ein vierter Keil K4 wird an den dritten Keil K3 gelegt, so dass ein Anschlag zur Begrenzung eines dritten Wickelpaketes WP3 entsteht, wobei dieser Anschlag in einer Ebene senkrecht zur Symmetrieachse z der Magnetspulenanordnung liegt.
j. Mit dem dritten bandförmiger Supraleiter BL3 werden mehrere Lagen eines dritten Wickelpakets WP3 in einem dritten axial begrenzten Wickelbereich gewickelt. Dieser Wickelbereich ist auf einer Seite durch die Anordnung der Keile K3; K4 begrenzt und auf der anderen Seite durch einen Flansch am Bandeingangs-Ende der Wickelkammer.
k. Der dritte bandförmiger Supraleiter BL3 wird durch den Bandausgang aus der Wickelkammer hinaus geführt.

Wenn mehr als drei Bandförmiger Supraleiter gewickelt werden sollen, werden die Schritte e, f, g und h für jeden zusätzlichen bandförmigen Supraleiter wiederholt.

Die Wickelfolge der Anordnung in Fig. 1a ist eine Kombination der beiden oben beschriebenen Wickelfolgen der Anordnungen nach den Figuren 1b und 1c.

Die Wickelfolge der Anordnung nach Fig. 1d, die eine besonders vorteilhafte Variante der Erfindung zeigt, ist ähnlich zur Wickelfolge der Anordnung nach Fig. 1c, wobei aber die beiden axialen Randbereiche der Spule mit dem selben bandförmigen Supraleiter BL1 gewickelt werden. Vorzugsweise hat der am Rand gewickelte bandförmige Supraleiter BL1 eine höhere Stromtragfähigkeit (z.B. durch größere Breite) als der in der Mitte gewickelte bandförmige Supraleiter BL2. In den Varianten der Fig. 1c und 1d wird - im Gegensatz zu den Varianten der Fig. 1a und 1b - kein Reservoir Re1; Re2 benötigt, weil alle bandförmigen Supraleiter BL1; BL2; BL3 in einem Zug vom Eingang bis zum Ausgang gewickelt werden.

Das Verfahren zum Wickeln der Anordnung gemäß Fig. 1d verläuft folgendermaßen:
a. Mit einem ersten bandförmiger Supraleiter BL1 wird eine Lage vom Bandeingang bis zum gegenüber liegenden Ende der Wickelkammer gewickelt.
b. Mit dem ersten bandförmiger Supraleiter BL1 werden mehrere Lagen eines ersten Wickelpakets WP1 in einem ersten axial begrenzten Wickelbereich gewickelt. Dieser Wickelbereich ist auf einer Seite durch einen Flansch am dem Bandeingang gegenüber liegenden Ende der Wickelkammer begrenzt und auf der anderen Seite durch einen ersten Keil K1.
c. Der erste bandförmiger Supraleiter BL1 wird über den ersten Keil K1 zum Wickelgrund geführt.
d. Der erste bandförmiger Supraleiter BL1 wird bis zum Flansch auf der Seite des Bandausgangs gewickelt.
e. Mit dem ersten bandförmiger Supraleiter BL1 werden mehrere Lagen eines weiteren Wickelpakets WP1' in einem zweiten axial begrenzten Wickelbereich gewickelt. Dieser Wickelbereich ist auf einer Seite durch den Flansch auf der Seite des Bandeingangs begrenzt und auf der anderen Seite durch einen dritten Keil K3.
f. Der erste bandförmiger Supraleiter BL1 wird durch den Bandausgang aus der Wickelkammer hinaus geführt.
g. Ein zweiter bandförmiger Supraleiter BL2 wird über das Wickelpaket WP1' bis zum Keil K3 gewickelt und über diesen zum Wickelgrund geführt.
h. Ein zweiter Keil K2 wird an den ersten Keil K1 und ein vierter Keil K4 wird an den dritten Keil K3 gelegt, so dass auf zwei Seiten je ein Anschlag zur Begrenzung eines zweiten Wickelpaketes WP2 entsteht, wobei beide Anschläge in je einer Ebene senkrecht zur Symmetrieachse z der Magnetspulenanordnung liegen.
i. Zwischen diesen beiden Anschlägen wird mit dem zweiten bandförmigen Supraleiter BL2 ein zweites Wickelpaket WP2 gewickelt, bis die letzte Lage des zweiten Wickelpaketes WP2 über das Wickelpaket WP1' bis zum Ausgang gewickelt und aus der Wickelkammer hinaus geführt werden kann.

Eine komplexere Variante der Erfindung ist in Fig. 2 dargestellt. Obwohl praktisch weniger bedeutend zeigt dieses Beispiel die allgemeine Anwendbarkeit der Erfindung. Die Folge aller Wickelschritte ist lang, jedoch klar realisierbar. In dieser Variante müssen nur zwei Reservoire Re1; Re2 angelegt werden, jeweils nach dem Wickeln des radial inneren und radial äußeren Bereichs ganz links. Diese zwei Reservoire Re1; Re2 müssen nie gleichzeitig bestehen, das zweite wird erst nach dem Auflösen des ersten angelegt.

Die Figuren 3a-c zeigen schematisch die Keilanordnung mit den Keilen K3; K4 von Fig. 1d. Sie dienen dazu, den zweiten bandförmigen Supraleiter BL2 von radial außen in den radial inneren Bereich der Spule zu führen. Zumindest eine Lage des zweiten bandförmigen Supraleiters BL2 wird über ein bereits gewickeltes Wickelpaket WP1' aus dem ersten bandförmigen Supraleiter BL1 gewickelt und über den Keil K3 in kürzest-möglicher axialer Distanz zu einem kleineren Wickelradius geführt. Der vierte Keil K4 wird an den dritten Keil K3 gelegt, so dass ein Anschlag zur Begrenzung des zweiten Wickelpaketes WP2 entsteht, wobei dieser Anschlag in einer Ebene senkrecht zur Symmetrieachse z der Magnetspulenanordnung liegt.

Zur besseren Anschaulichkeit zeigt Fig. 4 die beiden Keil-Enden leicht auseinandergespreizt. In eingebauter Lage ist diese Spreizung geschlossen. Diese Keilform ist besonders vorteilhaft, da innerhalb nur einer Windung der Leiter von einem Radius zu einem deutlich anderen geführt werden kann.

Wie in Fig. 4 verdeutlicht, werden die Keile K1; K2; K3; K4 durch folgende Parameter charakterisiert:
a) 0 ≤ A ≤ 4mm, insbesondere A < 1mm, wobei **A die Breite des dünnen Keil-Endes** bedeutet,
b) B = A + W, wobei **B die Breite des dicken Keil-Endes** und **W die Breite eines bandförmigen Supraleiters** BL1; BL2; BL3 bedeuten,
c) die Keile (K1; K2; K3; K4) erstrecken sich entlang einer vollen Windung des bandförmigen Supraleiters BL1; BL2; BL3 mit einer konstanten **Höhe ΔR** und die Höhe ΔR geht stetig zu 0 im Anschluss an die volle Windung innerhalb eines Winkels α < 180°, vorzugsweise innerhalb α < 60°.

Ein erheblicher Vorteil der erfindungsgemäßen Anordnung besteht unter anderem in der bereichsweisen Anpassung der Stromtragfähigkeit der bandförmigen Supraleiter BL1; BL2; BL3 an die Feldverteilung und Feldorientierung innerhalb der gesamten Spule. Dadurch werden die verwendeten bandförmigen Supraleiter BL1; BL2; BL3 optimal ausgenutzt und die Spule kann bei einem höheren Strom betrieben werden. Die benötigte Supraleitermenge und damit die Materialkosten sind geringer bzw. mit derselben Supraleitermenge kann ein höheres Magnetfeld im Spulenzentrum erzeugt werden.

### Bezugszeichenliste:

- 1; 1'; 1"; 1'": erster rechteckiger Teilbereich
- 2; 2'; 2"; 2'": zweiter rechteckiger Teilbereich
- 3; 3'; 3"; 3'": dritter rechteckiger Teilbereich
- 4; 4'; 4"; 4'": vierter rechteckiger Teilbereich (analog zum zweiten Teilbereich)
- BL1: erster bandförmiger Supraleiter
- BL2: zweiter bandförmiger Supraleiter
- BL3: dritter bandförmiger Supraleiter
- K1: erster Keil
- K2: zweiter Keil
- K3: dritter Keil
- K4: vierter Keil
- ΔR: Keilhöhe
- A: Breite des dünnen Keil-Endes
- B: Breite des dicken Keil-Endes
- W: Breite des bandförmigen Supraleiters
- SK: Spulenkörper
- WP1: erstes Wickelpaket
- WP2: zweites Wickelpaket
- WP3: drittes Wickelpaket
- WP1': weiteres Wickelpaket mit einem ersten bandförmigen Supraleiter BL1
- WS1: erste Wickelscheiben
- WS2: zweite Wickelscheiben
- Re1: erstes Reservoir
- Re2: zweites Reservoir
- z: Symmetrieachse der Magnetspulenanordnung

### Referenzliste:

Oben genannte Druckschriften aus dem Stand der Technik:
[1] DE 102 02 372 B4
[2] US 6,774,752 B2
[3] EP 2 906 961 B1
[4] DE 10 2004 043 987 B3
[5] US 9,117,578 B2

## Patentansprüche

1. Supraleitfähige Magnetspulenanordnung mit einer lagengewickelten, bezogen auf eine Symmetrieachse (z) zylindersymmetrischen Spule zur Erzeugung eines Betriebsmagnetfeldes in einem Arbeitsvolumen um die Symmetrieachse (z), und mit einer die Symmetrieachse (z) enthaltenden und die Spule schneidenden Schnittebene, wobei die Spule einen rechteckigen Spulenquerschnitt in der Schnittebene aufweist, der definiert ist durch einen radial inneren und radial äußeren sowie einen axial ersten und axial zweiten Spulenrand, definiert durch die Position einer radial innersten und einer radial äußersten Windung der Spule mit dem kleinsten bzw. größten Abstand zur Symmetrieachse (z), und durch die Position einer axial ersten und einer axial letzten Windung der Spule mit der kleinsten bzw. größten Koordinate entlang der Symmetrieachsenrichtung, wobei die Spule mindestens einen ersten bandförmigen Supraleiter (BL1) und einen zweiten bandförmigen Supraleiter (BL2) umfasst, wobei die bandförmigen Supraleiter ein Seitenverhältnis (Breite zu Dicke) > 3 aufweisen, wobei die bandförmigen Supraleiter (BL1, BL2) in einen Bereich außerhalb des rechteckigen Spulenquerschnitts geführt und dort elektrisch verbunden sind, und wobei die bandförmigen Supraleiter (BL1; BL2) unterschiedliche supraleitende Stromtragfähigkeiten bei gleichem Feld, bei gleicher Feldrichtung relativ zur Bandebene und bei gleicher Temperatur aufweisen,
**dadurch gekennzeichnet,**
**dass** die Spule aufweist:
einen ersten rechteckigen Teilbereich (1; 1'; 1"; 1'") innerhalb des rechteckigen Spulenquerschnitts, welcher den Spulenquerschnitt entlang der Symmetrieachsenrichtung vollständig überdeckt,
mindestens einen zweiten und dritten rechteckigen Teilbereich (2; 2'; 2"; 2'") und (3; 3'; 3"; 3'") innerhalb des ersten rechteckigen Teilbereichs (1; 1'; 1"; 1"'), welche den ersten rechteckigen Teilbereich jeweils radial vollständig und axial teilweise überdecken, wobei der zweite rechteckige Teilbereich (2; 2'; 2"; 2"') vollständig mit dem ersten bandförmigen Supraleiter (BL1) gewickelt ist und der dritte rechteckige Teilbereich (3; 3'; 3"; 3'") vollständig mit dem zweiten bandförmigen Supraleiter (BL2) gewickelt ist, und wobei der zweite und der dritte rechteckige Teilbereich (2; 2'; 2"; 2'") und (3; 3'; 3"; 3'") disjunkt sind.

2. Spulenanordnung nach Anspruch 1, **dadurch gekennzeichnet, dass** die Anzahl der Lagen des ersten rechteckigen Teilbereichs (1; 1'; 1"; 1'") größer als 3 ist.

3. Spulenanordnung nach Anspruch 1 oder 2, **dadurch gekennzeichnet, dass** die Anzahl an Windungen pro Lage im zweiten und dritten rechteckigen Teilbereich (2; 2'; 2"; 2"') und (3; 3'; 3"; 3'") größer als 3 ist.

4. Spulenanordnung nach einem der vorhergehenden Ansprüche, **dadurch gekennzeichnet, dass** die bandförmigen Supraleiter (BL1; BL2) so gewählt sind, dass ihre supraleitende Stromtragfähigkeit sowohl von der Feldamplitude als auch von der Feldrichtung relativ zur Bandebene abhängt.

5. Spulenanordnung nach einem der vorhergehenden Ansprüche, **dadurch gekennzeichnet, dass** ein Unterschied in der supraleitenden Stromtragfähigkeit der bandförmiger Supraleiter (BL1; BL2) zustande kommt, indem die Breite und/oder die Dicke der supraleitenden Schicht und/oder die Materialeigenschaften, insbesondere die chemische Zusammensetzung, der supraleitenden Schicht unterschiedlich gewählt sind.

6. Spulenanordnung nach einem der vorhergehenden Ansprüche, **dadurch gekennzeichnet, dass** der Querschnitt des ersten bandförmigen Supraleiters (BL1) unterschiedlich vom Querschnitt des zweiten bandförmigen Supraleiters (BL2) gewählt ist.

7. Spulenanordnung nach einem der vorhergehenden Ansprüche, **dadurch gekennzeichnet, dass** die bandförmigen Supraleiter (BL1; BL2) über eine Fläche > 1cm², vorzugsweise > 10cm², mit einem Übergangswiderstand kleiner als 10⁻⁶ Ohm, vorzugsweise kleiner als 10⁻⁸ Ohm, miteinander verlötet oder mit einem Übergangswiderstand kleiner als 10⁻⁸ Ohm supraleitend verbunden sind.

8. Spulenanordnung nach einem der vorhergehenden Ansprüche, **dadurch gekennzeichnet, dass** die bandförmigen Supraleiter (BL1; BL2) aus einem HTS-, d.h. Hochtemperatur-Supraleiter-, Material bestehen, insbesondere vom Typ ReBCO, wobei Re = "Seltene Erden", insbesondere Yttrium.

9. Spulenanordnung nach einem der vorhergehenden Ansprüche, **dadurch gekennzeichnet, dass** die Magnetspulenanordnung ein NMR-Hochfeldmagnet ist, in dessen Zentrum ein homogenes Magnetfeld erzeugt wird.

10. Spulenanordnung nach einem der vorhergehenden Ansprüche, **dadurch gekennzeichnet, dass** mindestens zwei der bandförmigen Supraleiter (BL1; BL2) in dem zweiten und dem dritten rechteckigen Teilbereich (2; 2'; 2"; 2'") und (3; 3'; 3"; 3"') durch Keile (K1; K2; K3; K4) getrennt sind.

11. Spulenanordnung nach Anspruch 10, **dadurch gekennzeichnet, dass** mindestens einer der bandförmigen Supraleiter (BL1) mit einem ersten Keil (K1; K3) von einer ersten Lage zu einer zweiten, radial weiter innen liegenden, Lage geführt wird.

12. Spulenanordnung nach Anspruch 11, **dadurch gekennzeichnet, dass** ein zweiter Keil (K2; K4) als Gegenstück zum ersten Keil (K1; K3) vorhanden ist und einen Anschlag für das Wickeln eines zweiten der bandförmigen Supraleiter (BL2) bildet.

13. Spulenanordnung nach einem der Ansprüche 10 bis 12, **dadurch gekennzeichnet, dass** die Keile (K1; K2; K3; K4) folgende Parameter aufweisen:
a) 0 ≤ A ≤ 4mm, insbesondere A < 1mm, wobei A die Breite des dünnen Keil-Endes bedeutet;
b) B = A + W, wobei B die Breite des dicken Keil-Endes und W die Breite eines bandförmigen Supraleiters bedeuten;
c) die Keile (K1; K2; K3; K4) erstrecken sich entlang einer vollen Windung des bandförmigen Supraleiters mit einer konstanten Höhe (ΔR) und die Höhe (ΔR) geht stetig zu 0 im Anschluss an die volle Windung innerhalb eines Winkels α < 180°, vorzugsweise innerhalb α < 60°.

14. Spulenanordnung nach einem der Ansprüche 10 bis 13, **dadurch gekennzeichnet, dass** mehrere der bandförmigen Supraleiter über ein und denselben Keil (K1; K3) geführt sind.

15. Verfahren zur Herstellung einer supraleitfähigen Magnetspulenanordnung nach einem der vorhergehenden Ansprüche durch Wickeln der mindestens zwei bandförmigen Supraleitern (BL1; BL2) in mindestens dem zweiten und dritten rechteckigen Teilbereich (2; 2'; 2"; 2"') und (3; 3'; 3"; 3"'), **gekennzeichnet durch** folgende Schritte:
• Wickeln mindestens einer Lage des ersten bandförmigen Supraleiters (BL1) lagenweise entlang der Symmetrieachsenrichtung in dem zweiten rechteckigen Teilbereich (2; 2'; 2"; 2"'),
• Wickeln mindestens zweier Lagen des zweiten bandförmigen Supraleiters (BL2) lagenweise entlang der Richtung der Symmetrieachse (z) in dem dritten rechteckigen Teilbereich (3; 3'; 3"; 3'"), wobei ein Reservoir (Re1) mit einer später benötigten Menge des ersten bandförmigen Supraleiters (BL1) mitdreht,
• Wickeln mindestens einer weiteren Lage des ersten bandförmigen Supraleiters (BL1) über den im vorgängigen Schritt gewickelten zweiten bandförmigen Supraleiter (BL2) mit der im Reservoir aufbewahrten Bandlänge des ersten bandförmigen Supraleiters (BL1).

## Claims

1. Superconductive magnet coil assembly comprising a layer-wound coil that is cylindrically symmetric with respect to an axis of symmetry (z) and is intended for generating an operating magnetic field in a working volume around the axis of symmetry (z), and having a sectional plane that contains the axis of symmetry (z) and intersects the coil, the coil having a rectangular coil cross section in the sectional plane, which cross section is defined by a radially inner and radially outer and a first axial and second axial coil edge defined by the position of a radially innermost winding and a radially outermost winding of the coil that are at the smallest and largest distance, respectively, from the axis of symmetry (z), and by the position of a first axial and a last axial winding of the coil having the smallest and largest coordinates, respectively, in the direction of the axis of symmetry, the coil comprising at least one first strip-like superconductor (BL1) and one second strip-like superconductor (BL2), the strip-like superconductors having a width-to-height (width to thickness) ratio of > 3, the strip-like superconductors (BL1; BL2) being guided into a region outside the rectangular coil cross section and being electrically connected there, the strip-like superconductors (BL1; BL2) having different superconducting current-carrying capacities when the field, the field direction relative to the strip plane, and the temperature, are the same,
**characterized in that**
the coil comprises:
a first rectangular portion (1; 1'; 1"; 1'") within the rectangular coil cross section which completely covers the coil cross section in the direction of the axis of symmetry,
at least one second and third rectangular portion (2; 2'; 2"; 2"') and (3; 3'; 3"; 3"') within the first rectangular portion (1; 1'; 1"; 1'") which cover the first rectangular portion completely in the radial direction and in part in the axial direction, the second rectangular portion (2; 2'; 2"; 2"') being completely wound with the first strip-like superconductor (BL1), and the third rectangular portion (3; 3'; 3"; 3"') being completely wound with the second strip-like superconductor (BL2), and the second and the third rectangular portion (2; 2'; 2"; 2"') and (3; 3'; 3"; 3"') being disjunct.

2. Coil assembly according to claim 1, **characterized in that** the number of layers in the first rectangular portion (1; 1'; 1"; 1"') is greater than 3.

3. Coil assembly according to either claim 1 or claim 2, **characterized in that** the number of windings per layer in the second and third rectangular portion (2; 2'; 2"; 2'") and (3; 3'; 3"; 3'") is greater than 3.

4. Coil assembly according to any of the preceding claims, **characterized in that** the strip-like superconductors (BL1; BL2) are selected such that their superconducting current-carrying capacity is dependent both on the field amplitude and on the field direction relative to the strip plane.

5. Coil assembly according to any of the preceding claims, **characterized in that** a difference in the superconducting current-carrying capacity of the strip-like superconductors (BL1; BL2) results from the width and/or the thickness of the superconducting layer and/or the material properties, in particular the chemical composition, of the superconducting layer being selected so as to be different.

6. Coil assembly according to any of the preceding claims, **characterized in that** the cross section of the first strip-like superconductor (BL1) is selected so as to be different from the cross section of the second strip-like superconductor (BL2).

7. Coil assembly according to any of the preceding claims, **characterized in that** the strip-like superconductors (BL1; BL2) are soldered together over a surface area of > 1 cm², preferably > 10 cm², and at a transition resistance of less than 10⁻⁶ ohms, preferably < 10⁻⁸ ohms, or are connected in a superconducting manner at a transition resistance of less than 10⁻⁸ ohms.

8. Coil assembly according to any of the preceding claims, **characterized in that** the strip-like superconductors (BL1; BL2) consist of an HTS, i.e. high-temperature superconductor material, in particular of the type ReBCO, wherein Re = "rare earth", in particular yttrium.

9. Coil assembly according to any of the preceding claims, **characterized in that** the magnet coil assembly is an NMR high field magnet, in the center of which a homogenous magnetic field is generated.

10. Coil assembly according to any of the preceding claims, **characterized in that** at least two of the strip-like superconductors (BL1, BL2) are separated, in the second and the third rectangular portion (2; 2'; 2"; 2'") and (3; 3'; 3"; 3"'), by wedges (K1; K2; K3; K4).

11. Coil assembly according to claim 10, **characterized in that** at least one of the strip-like superconductors (BL1) is guided by a first wedge (K1; K3) from a first layer to a second, radially more inner, layer.

12. Coil assembly according to claim 11, **characterized in that** a second wedge (K2; K4) is present as a counterpart to the first wedge (K1; K3) and forms a stop for winding a second of the strip-like superconductors (BL2).

13. Coil assembly according to any of claims 10 to 12, **characterized in that** the wedges (K1; K2; K3; K4) have the following parameters:
a) 0 ≤ A ≤ 4 mm, in particular A < 1 mm, where A is the width of the thin end of the wedge;
b) B = A + W, where B is the width of the thick end of the wedge and W is the width of a strip-like superconductor;
c) the wedges (K1; K2; K3; K4) extend along a complete winding of the strip-like superconductor at a constant height (ΔR) and the height (ΔR) transitions steadily to 0 at the end of the complete winding, within an angle α < 180°, preferably within α < 60°.

14. Coil assembly according to any of claims 10 to 13, **characterized in that** a plurality of the strip-like superconductors are guided over the same wedge (K1; K3).

15. Method for producing a superconductive magnet coil assembly according to any of the preceding claims by winding the at least two strip-like superconductors (BL1, BL2) in at least the second and third rectangular portion (2; 2'; 2"; 2'") and (3; 3'; 3"; 3"'), **characterized by** the following steps:
• winding at least one layer of the first strip-like superconductor (BL1) in layers in the direction of the axis of symmetry in the second rectangular portion (2; 2'; 2"; 2'"),
• winding at least two layers of the second strip-like superconductor (BL2) in layers in the direction of the axis of symmetry (z) in the third rectangular portion (3; 3'; 3"; 3"'), a store (Re1) containing an amount of the first strip-like superconductor (BL1) required later corotating therewith,
• winding at least one further layer of the first strip-like superconductor (BL1) over the second strip-like superconductor (BL2) wound in the preceding step, using the strip length of the first strip-like superconductor (BL1) kept in the store.

## Revendications

1. Agencement de bobine magnétique supraconductrice comportant une bobine enroulée en couches, à symétrie cylindrique par rapport à un axe de symétrie (z) pour générer un champ magnétique de fonctionnement dans un volume de travail autour de l'axe de symétrie (z) et comportant un plan de coupe qui contient l'axe de symétrie (z) et coupe la bobine, la bobine présentant une section transversale de bobine rectangulaire dans le plan de coupe, qui est définie par un bord de bobine radialement intérieur et un bord de bobine radialement extérieur ainsi qu'un premier bord de bobine axialement et un deuxième bord de bobine axialement, définis par la position d'une spire radialement la plus intérieure et d'une spire radialement la plus extérieure de la bobine ayant respectivement la plus petite et la plus grande distance par rapport à l'axe de symétrie (z), et par la position d'une première spire axialement et d'une dernière spire axialement de la bobine ayant respectivement la plus petite et la plus grande coordonnée dans la direction de l'axe de symétrie, la bobine comprenant au moins un premier supraconducteur en ruban (BL1) et un deuxième supraconducteur en ruban (BL2), les supraconducteurs en ruban ayant un rapport d'aspect (largeur/épaisseur) > 3, les supraconducteurs en ruban (BL1, BL2) étant guidés dans une zone extérieure à la section transversale de bobine rectangulaire et y étant électriquement connectés, et les supraconducteurs en ruban (BL1 ; BL2) présentant des intensités admissibles de courant supraconducteur différentes pour un même champ, une même direction de champ par rapport au plan de ruban et une même température,
**caractérisé en ce que**
la bobine présente :
une première zone partielle rectangulaire (1 ; 1' ; 1" ; 1'") à l'intérieur de la section transversale de bobine rectangulaire, qui recouvre complètement la section transversale de bobine dans la direction de l'axe de symétrie,
au moins une deuxième et une troisième zone partielle rectangulaire (2 ; 2' ; 2" ; 2"') et (3 ; 3' ; 3" ; 3'") à l'intérieur de la première zone partielle rectangulaire (1 ; 1' ; 1" ; 1'"), qui recouvrent respectivement radialement complètement et axialement partiellement la première zone partielle rectangulaire, la deuxième zone partielle rectangulaire (2 ; 2' ; 2" ; 2"') étant complètement enroulée avec le premier supraconducteur en ruban (BL1) et la troisième zone partielle rectangulaire (3 ; 3' ; 3" ; 3"') complètement enroulée avec le deuxième supraconducteur en ruban (BL2), et la deuxième et la troisième zone partielle rectangulaire (2 ; 2' ; 2" ; 2"') et (3 ; 3' ; 3" ; 3"') étant disjointes.

2. Agencement de bobine selon la revendication 1, **caractérisé en ce que** le nombre de couches de la première zone partielle rectangulaire (1 ; 1' ; 1" ; 1"') est supérieur à 3.

3. Agencement de bobine selon la revendication 1 ou 2, **caractérisé en ce que** le nombre de spires par couche dans la deuxième et la troisième zone partielle rectangulaire (2 ; 2' ; 2" ; 2"') et (3 ; 3' ; 3" ; 3"') est supérieur à 3.

4. Agencement de bobine selon l'une des revendications précédentes, **caractérisé en ce que** les supraconducteurs en ruban (BL1 ; BL2) sont choisis de telle sorte que leur intensité admissible de courant supraconducteur dépende à la fois de l'amplitude de champ et de la direction de champ par rapport au plan de ruban.

5. Agencement de bobine selon l'une des revendications précédentes, **caractérisé en ce qu'**une différence dans l'intensité admissible de courant supraconducteur des supraconducteurs en ruban (BL1 ; BL2) est obtenue en choisissant différemment la largeur et/ou l'épaisseur de la couche supraconductrice et/ou les propriétés matérielles, en particulier la composition chimique, de la couche supraconductrice.

6. Agencement de bobine selon l'une des revendications précédentes, **caractérisé en ce que** la section transversale du premier supraconducteur en ruban (BL1) est choisie différente de celle du deuxième supraconducteur en ruban (BL2).

7. Agencement de bobine selon l'une des revendications précédentes, **caractérisé en ce que** les supraconducteurs en ruban (BL1 ; BL2) sont soudés entre eux par une surface > 1 cm², de préférence > 10 cm², avec une résistance de contact inférieure à 10⁻⁶ ohms, de préférence inférieure à 10⁻⁸ ohms, ou sont reliés de façon supraconductrice avec une résistance de contact inférieure à 10⁻⁸ ohms.

8. Agencement de bobine selon l'une des revendications précédentes, **caractérisé en ce que** les supraconducteurs en ruban (BL1 ; BL2) sont constitués d'un matériau HTS, c'est-à-dire d'un supraconducteur à haute température, en particulier du type ReBCO, où Re = « terres rares », en particulier de l'yttrium.

9. Agencement de bobine selon l'une des revendications précédentes, **caractérisé en ce que** l'agencement de bobine magnétique est un aimant de RMN à champ élevé au centre duquel un champ magnétique homogène est généré.

10. Agencement de bobine selon l'une des revendications précédentes, **caractérisé en ce qu'**au moins deux des supraconducteurs en ruban (BL1 ; BL2) sont séparés par des coins (K1 ; K2 ; K3 ; K4) dans la deuxième et la troisième zone partielle rectangulaire (2 ; 2' ; 2" ; 2"') et (3 ; 3' ; 3" ; 3"').

11. Agencement de bobine selon la revendication 10, **caractérisé en ce qu'**au moins l'un des supraconducteurs en ruban (BL1) est guidé par un premier coin (K1 ; K3) d'une première couche à une deuxième couche située radialement plus à l'intérieur.

12. Agencement de bobine selon la revendication 11, **caractérisé en ce qu'**un deuxième coin (K2 ; K4) est présent en tant que pièce complémentaire du premier coin (K1 ; K3) et forme une butée pour l'enroulement d'un deuxième des supraconducteurs en ruban (BL2).

13. Agencement de bobine selon l'une des revendications 10 à 12, **caractérisé en ce que** les coins (K1 ; K2 ; K3 ; K4) présentent les paramètres suivants :
a) 0 ≤ A ≤ 4 mm, en particulier A < 1 mm, où A représente la largeur de l'extrémité mince du coin ;
b) B = A + W, où B représente la largeur de l'extrémité épaisse du coin et W la largeur d'un supraconducteur en ruban ;
c) les coins (Kl, K2 ; K3 ; K4) s'étendent le long d'une spire complète du supraconducteur en ruban avec une hauteur constante (ΔR) et la hauteur (ΔR) tend continuellement vers 0 après la spire complète selon un angle α < 180°, de préférence selon un angle α < 60°.

14. Agencement de bobine selon l'une des revendications 10 à 13, **caractérisé en ce que** plusieurs des supraconducteurs en ruban sont guidés par un seul et même coin (K1 ; K3).

15. Procédé de fabrication d'un agencement de bobine magnétique supraconductrice selon l'une des revendications précédentes par enroulement desdits au moins deux supraconducteurs en ruban (BL1 ; BL2) dans au moins la deuxième et la troisième zone partielle rectangulaire (2 ; 2' ; 2" ; 2"') et (3 ; 3' ; 3" ; 3"'), **caractérisé par** les étapes suivantes :
- enroulement d'au moins une couche du premier supraconducteur en ruban (BL1) en couches dans la direction de l'axe de symétrie dans la deuxième zone partielle rectangulaire (2 ; 2' ; 2" ; 2"'),
- enroulement d'au moins deux couches du deuxième supraconducteur en ruban (BL2) en couches dans la direction de l'axe de symétrie (z) dans la troisième zone partielle rectangulaire (3 ; 3' ; 3" ; 3"'), un réservoir (Re1) avec une quantité ultérieurement requise du premier supraconducteur en ruban (BL1) tournant en même temps,
- enroulement d'au moins une autre couche du premier supraconducteur en ruban (BL1) sur le deuxième supraconducteur en ruban (BL2) enroulé à l'étape précédente avec la longueur de ruban du premier supraconducteur en ruban (BL1) stockée dans le réservoir.
